# EUROPEAN PATENT SPECIFICATION

(11) **EP 2 051 379 B1**
(45) Date of publication and mention of the grant of the patent: **12.01.2011**
(21) Application number: 08166746.1
(22) Date of filing: 16.10.2008
(51) Int. Cl.: H03J 1/00, H02J 9/00, H02M 3/33

(54) **Intelligent home automation system providing power saving In standby mode**
Intelligentes Heimautomatisierungssystem mit Stromspareffekt im Bereitschaftsmodus
Système d'automatisation de maison intelligente fournissant un mode de veille à économie d'énergie

(30) Priority: 16.10.2007 TR 200707051
(43) Date of publication of application: 22.04.2009
(73) Proprietor: Vestel Elektronik Sanayi ve Ticaret A.S., 45030 Manisa (TR)
(72) Inventor: Boran, Baris, 45030, MANISA (TR); Basarir, Cenk, 45030, MANISA (TR)
(74) Representative: Cayli, Hülya

(56) References cited:
- EP-A- 0 982 941
- EP-A- 1 653 572
- EP-A- 1 708 331
- GB-A- 2 430 555
- JP-A- 2001 268 654
- US-A1- 2002 036 910
- US-A1- 2004 254 683
- US-A1- 2006 273 663

## Description

### Field of Invention

The present invention relates to a method and system to provide power saving for electronic devices while such devices are in the standby mode and are not in use, particularly for a setting accommodating multiple electronic devices especially in the end-user sector.

### Prior Art

Many electronic products in the end-user electronics market are being manufactured so as to be switched to the standby mode and thereafter to wake and start up depending on the user's preference or any other external factor without any delay, besides the regular turn ON and OFF functions thereof. Television systems, satellite receivers (DVBs), devices recording from satellite broadcasts (PVRs), audio systems, DVD players and many similar electronic devices widely used in the end-user electronics market consume energy in their standby mode, though the amount of energy consumed in this mode is less as compared to their operating mode.

Many approaches are available in the background art, aiming at reducing the energy consumption in the standby periods of such electronic devices. Whilst such approaches can reduce the energy consumption during the standby period there is still a certain degree of energy consumption, and even in the case where the energy consumption approaches to zero in the standby more, the user becomes obliged to turn off or switch to the standby mode each such devices individually, when he/she wishes to turn off or switch to the standby mode all such electronic devices under use.

In the patent application US20040254683A1 -among such known approaches- there is disclosed a system whereby multiple electronic devices connected thereto are controlled with respect to their OFF or standby modes. In this disclosed system, multiple electronic devices individually establish data exchange with a single hub (i.e. center) so that if any device connected externally to this system is to be controlled, the current mode of this device is monitored and controlled accordingly.

In the background art, when any device is turned off or switched to the standby mode, other devices connected to the former device or other device not to be run when the former device is out of use are also shut down by the user.

In the context of the background art, it is a requirement that electronic devices establish communication with their control hubs and transmit signals about their current status. Such known approaches are applicable only to devices capable to establish communication with a hub, wherein each electronic device which switches to the standby mode cannot be controlled under such known approaches.

In the background art, EP 0 982 941 A document describes a switching device, comprising switching means for switching a set of conductors and receiving means for receiving, without the use of wires, control signals from a control device. Said switching device receives on and off signals which are transmitted by an electrical appliance's remote-control device. According to said signals, said switch device cuts the current feed (turn off condition) of the electrical appliance or re-establish the connection (turn on condition). However, this invention is applicable only for one electrical device not for an electronic system. Moreover, in EP 0 982 941 A_do not involve a non-volatile memory. Also, EP 0 982 941 A do not let the device stay in standby mode, it directly cuts the current feed without a delay.

### Objective of Invention

The objective of the present invention is to develop a method and system, which can control the turning OFF and/or the switching to the standby mode of numerous electronic devices in a setting accommodating multiple electronic devices controllable by means of remote controllers.

Another objective of the present invention is to reduce the standby-period power consumption of one or many electronic devices in a setting accommodating numerous electronic devices.

A further objective of the present invention is to automatically turn off or switch to the standby mode other electronic devices, which are selected not to run if any other device is turned off or in the standby mode.

### Description of Figures

The present invention is to be disclosed hereunder with references made to annexed figures outlined as following.
Figure 1 is a block diagram representing the end-user electronic devices included in a system according to the present invention, and the interrelation of such devices within this system.
Figure 2 is a block diagram representing the end-user electronic devices included in a system according to the present invention, and the relation of a controller with such devices to control them within this system.
Figure 3 is a block diagram representing the internal structure of a controller employed according to the present invention.

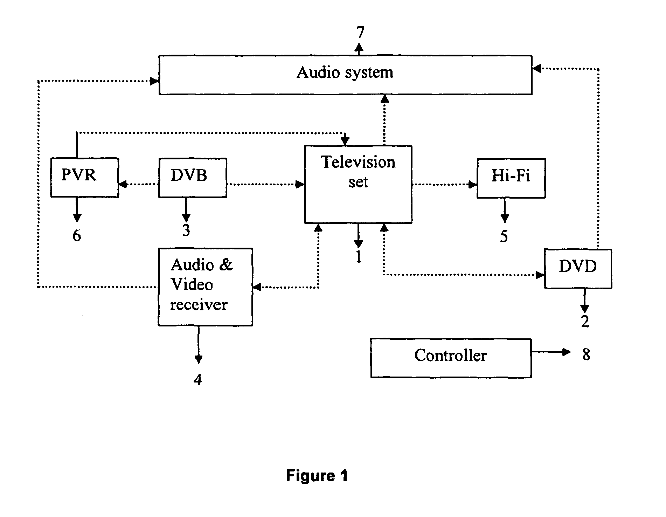

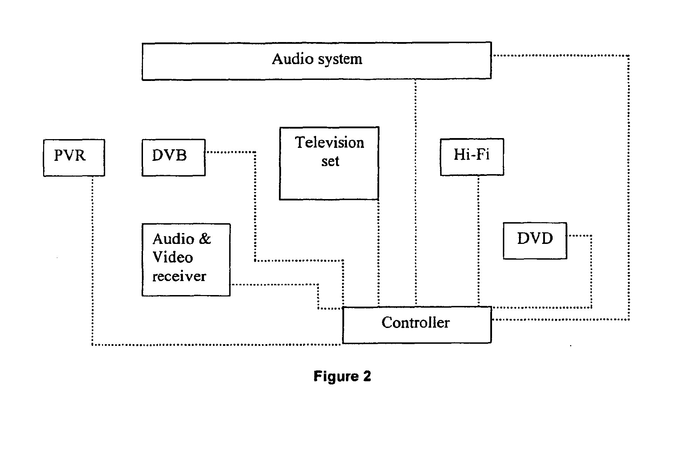

The reference numbers as used in figures 1 and 2 of the subject system may possess the following meanings.
1- a television, CRT, LCD or a plasma television;
2- a DVD player, any device to read DVD disks;
3- a DVB receiver, a satellite receiver;
4- an audio/video receiver, any device used for controlling multiple audio and video sources;
5- an Hi Fi sound system, any system incorporating functions such as radio receivers, cassette players;
6- a PVR recorder, any device for receiving satellite broadcasts and recording on its memory the broadcasted programs;
7- an audio system, e.g. a 5+1 audio system with a total of six audio outputs.

### Description of Invention

The basic function of the present invention is to control the ON, the standby, and the OFF status of electronic devices by means of a controller in a setting accommodating many such electronic devices each controllable by a remote controller.

Under the working principle of the present invention, it has been assumed that the electronic devices and the controllers controlling such electronic devices are capable to receive the remote controller signals, to respond to remote controller signals, and to be controlled by means of a remote controller. It has further been assumed that all such audio and video systems have remote controllers and are capable to switch to the standby mode or to switch from the standby mode back to the operating mode.

According to the working principle of the present invention, the plugs (i.e. wall plugs) to connect such electronic devices are placed on a controller. Each plug for a predetermined electronic device is placed previously by the manufacturer on the controller and the locations of such plugs to connect the electronic devices can be interchanged by the user or manufacturer.

This controller, whereon the plugs are designated individually for each device, comprises at least one signal receiver and at least one signal transmitter unit similar to those provided on such electronic devices, at least one memory, power supply, and at least one microprocessor.

It is further known -with respect to the working principle of the present invention- as to which electronic devices are not to run, while which electronic devices are in their switched off/standby modes. For instance, when a television is OFF, it is unnecessary to run the audio and video receiver. It is previously stored on the memory of the subject controller as to which devices run together with which devices, along with the meanings of the remote controller commands. Nowadays, many remote controllers do operate on a certain communication protocol. In the end-user electronics market, for instance, many of the up-to-date devices establish communication via infrared rays, and make use of the RC5 protocol developed by Philips as the remote control protocol; additionally, the meanings of, or the individual devices to receive the signals transmitted under RC5 or under many other protocols can be determined or previously known. In this example of the present invention, it has been assumed that each electronic device connected to the controller is capable of building communication with the respective remote controller, and that signals transmitted from each device are sensed and resolved/distinguished by the receiver/transmitter connected to the controller.

When the user transmits a signal by means of a remote controller to switch a device that is controllable by the remote controller to the standby mode or to wake up such device at the standby mode, this signal is sensed also by the signal receiver provided on the controller. If a television is switched to the standby mode by means of a remote controller, for example, the standby signal sent by the user via the remote controller is sensed at the same time by the controller. In this case, while the television system switches to the standby mode thanks to an electronic arrangement incorporated into it, the controller sensing the same signal shall completely interrupt the power of this television now in the standby mode after a short period of time. The remote controller communication protocols (RC5 etc.), the meanings of signals in such protocols, and the data on which rule to apply on what circumstance are previously stored by the manufacturer on the memory in the controller. In addition to infrared rays, the electronic devices can be controlled by radio signals or by any other known remote control methods as well. The signals used to control the electronic devices are also sensed by the controller. The controlling unit is designed so as to individually or collectively interrupt the power of electronic device(s) connected to it. Turning back to this example, after the' television is switched to the standby mode by the user, the power of the television system is completely interrupted, with the controller sensing the same signal and executing a predetermined shutting-down rule. This system illustrating an embodiment of the present invention is to be detailed in Figure 1, Figure 2, and Figure 3.

In Figure 1, the interaction of and between electronic devices are illustrated. For instance a DVD player shown with reference number "2" in this Figure can both be used to have played DVD-formatted movies on the television display, and to listen to music. Therefore the DVD player is associated both with the television (1), and the audio system (7).

In the system shown in Figure 2, the interconnection of electronic devices (ranging from reference numbers "1" to "7") with the controller and their (1-7) power supply from the same controller are illustrated. There are plugs (not shown in Figure 1) provided on the controller unit, and each device is connected to a plug previously reserved for it. Such plugs are designed by the manufacturer beforehand and there may be provided more than one plug on the controller for a certain type of device. There may be provided plugs for two DVBs on the controller, for instance. After the devices are connected to previously determined plugs on the controller unit, the signals transmitted for controlling the devices are sensed by the controller unit as well, and if any such device(s) receive(s) a standby mode signal, the power of one or more of such device(s) shall be interrupted in accordance with the rules previously stored on the memory of the controller. In a system as exemplified in Figure 1 and Figure 2, if the television is turned OFF, it becomes unnecessary to have running the DVD player or video/audio receiver (i.e. ON mode). In such a system, when it is desired to turn OFF the television system, for instance when the user transmits a signal from the remote controller of the television to switch the television to the standby mode, this signal shall be sensed by the controller at the same time, the data to switch the television to the standby mode shall be received, and the power of the DVD player and the video/audio receiver shall be interrupted together with the power of the television. Thanks to this feature, the power shall be saved that the television would be spending during the standby period, together with the power that the DVD player and video/audio receiver would be spending during their ON or standby period.

Since, according to the control rules, there will not be left any device to watch or listen when e.g. the DVD, DVB, PVR, video/audio receiver devices are turned OFF, the controller can automatically shut down the television and the audio system among the devices connected to itself and save power. With respect to the working principle, the controller senses all remote control signals transmitted to the devices connected to it, knows that which devices are ON, are OFF, and are in the standby mode, and turns OFF any unnecessarily operating devices among them based on amendable predetermined rules. The control rules stored on the controller unit's memory may be more than one, and these rules can be changed according to the structure of the controller unit.

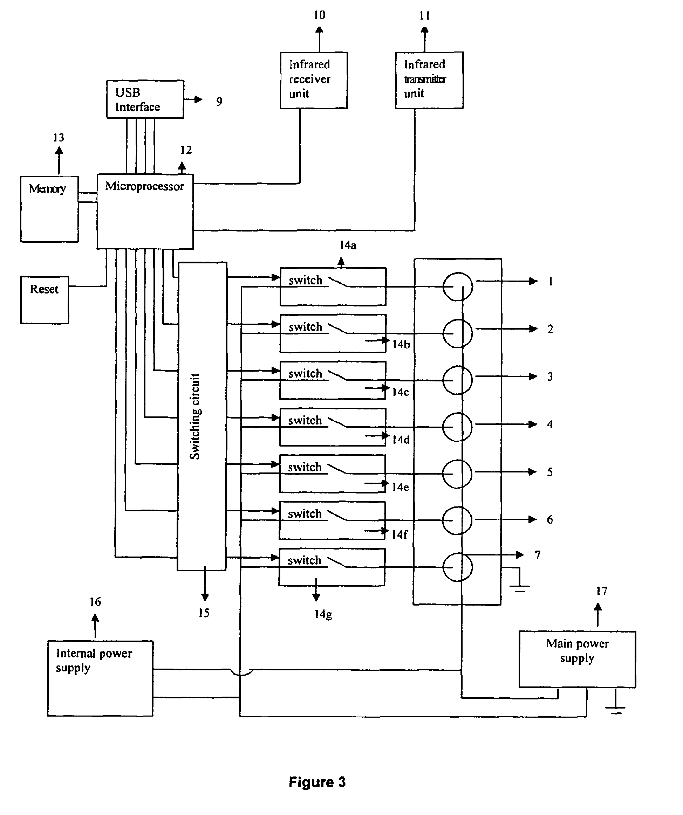

The structure of the controller is given in Figure 3. As can be seen in Figure 3, the controller may include many power switches (14a-14g) capable to powering on and off the relevant units, an internal memory (13), a microprocessor (12), a signal receiving (10) - transmitting (11) unit (an infrared signal transceiver for this example), a main power supply (17) for the controller's power consumption and an internal power supply (16), a bus (9) to change data on the controller's memory; this bus is an USB bus in this case, whereas the data stored on the internal memory within the controller can be altered by means of the USB bus and the microprocessor in the controller so as to assign new control rules. For instance, the plug outputs are previously assigned for certain devices, as illustrated in Figure 3. By means of special software, the user can store on the controller's memory as to which devices he/she uses or not uses. As differing from the system given in Figure 1 and Figure 2, a user with two DVB devices at home in place of a DVD device can communicate the system that a DVB device is to be connected to the point shown with reference number "2" in Figure 3 by means of a special software, and can designate as to which device is to be connected to which plug. It should be kept in mind that the data exchange of and between the controller and the exterior can also be made by many other methods in place of the USB bus; there may be provided a computer output on the controller as well, in order to build communication with a computer. It has been assumed here, that the signals of remote controls of electronic devices connected to the subject controller is sensed, identified, and interpreted by the controller.

The devices which are switched to standby from the ON mode by means of a remote control under the present invention, are first switched to the standby mode by their internal electronics, and then, their power is interrupted by means of the controller according to a predetermined shutting-off rule. In order to turn ON any such devices with their power turned OFF, the user depresses any keys on the remote control in the first step. The controller unit identifies as to which electronic device's remote control the user has depressed by means of the signal receiver (10) on itself, and then, allows power to be supplied to the relevant electronic device according to the ON/OFF status of devices stored on its memory (13), and to a turning-ON rule stored on its microprocessor (12), so that the electronic device to be controlled by the remote control is switched to standby mode by the controller. In the second step, the signal transmitter unit (11) on the controller transmits the turning-ON signal of that electronic device to that electronic device to wake up that device, in other words, it sends the signal which it receives in the first step to that electronic device in the second step. For instance, it is here assumed that the seven electronic devices shown in Figure 1 and Figure 2 are connected to the controller in Figure 3, that no power is supplied to any electronic device as depicted in the switch structure in Figure 3, and that all devices are OFF for a certain moment. In this circumstance, when the DVD player is to be turned ON by the user and the user sends a signal to turn ON the DVD player by the remote control of the DVD player, this signal is not sensed by the turned-OFF DVD player, but by the signal receiver unit (10) of the controller, and thus, the DVD player's switch (14a) which is open at that moment is closed (14b) and power is supplied accordingly. The DVD player now supplied with power as it was turned OFF shall switch to the standby mode and the user will then give wake up/turn ON command to the DVD player by means of the remote control. According to the present invention, either the user can give a wake up/turn ON command to turn ON the DVD player, or the controller, which already received the signal, can supply power to the DVD player at the first step, then at the second step, can transmit the same signal (i.e. the signal to turn ON the DVD player) sent to itself to the DVD player by means of the signal transmitter (11). Thanks to this feature, a DVD player -which is entirely OFF and cannot respond to a turn-ON signal to be sent to itself by means of a remote controller- is first supplied with power according to the present invention, then the waking-up/turning-ON of said DVD player can be ensured by means of a turning-ON rule. As differing from the background art, the fact that the controller first supplies power to the DVD player, and then switches it to the standby mode, after receiving a wake-up command from the remote control of this DVD player by the user avoids the DVD player from consuming power during the standby period, and the completely OFF-powered DVD player is turned ON (wake up) by means of a single key according to the present invention. When the user sends a single turn-ON signal only to the DVD player in this example (where all devices are turned OFF), the television to watch the video of the DVD player and the audio system to listen to the sound of the DVD player -besides the DVD player itself- can be powered ON as well in accordance with the turning-ON rules previously stored on the controller, and the infrared signal transmitter on the controller can send a signal to entirely turn ON these devices. The meanings of infrared signals are stored on the internal memory of the controller and when the controller receives a signal to turn ON any device, it first supplies power to the previously OFF-powered relevant device according to this signal, then runs this device by means of the signal transmitter on itself. Such turning-ON rules can be altered externally like the turning-OFF rules and any such altered rules can be stored on the controller's memory via the USB bus and be assigned as new turning-ON rules.

According to the present invention, the remote control signals controlling the devices connected to the controller can also be sensed by the controller. The controller can be set to a predetermined time period in order to save power, and if no signal is received within this time period from a remote control of any device connected to it, the controller can turn OFF such devices in turn or at the same time according to a predetermined power saving rule. For instance, the user can adjust the automatic turn-OFF time period as three hours, when no response is received during this period. In this example, if the user does not depress any key on any remote control of any electronic device connected to the controller, or if no signal is sensed by the controller within three hours, the controller may power off the electronic devices connected to itself in sequence according to an automatic turning-off rule. Whenever the user depresses on any key in this predetermined time period, the predetermined time period may be reinitiated. In the system shown in Figure 1 and Figure 2, and in an instance where the automatic turning-off period is set to three hours and an assumption that an automatic turning-off rule is present and that all devices are ON, if the user does not depress any key within three hours, first the audio system is turned off automatically, then the other devices are shut down in a predetermined and alterable sequence. In the same example, if the user depresses any keys on any of the remote controls one hour prior to the completion of the time period for instance, the three-hour time period shall be reinitiated, and a sign shall be waited for that the user makes use of such electronic devices once in each three-hour period. If no remote control signal is received the power saving rule to be executed may be a predetermined rule by the manufacturer, and may be altered by means of the data bus (9) on the controller by the user or manufacturer, and according to the power saving rules, a device can either be turned off, or switched to the standby mode.

In accordance with the power saving rules, any device with its power turned off may be opened, i.e. turned on, by any turning-off methods according to the present invention, if the user wishes this device to be turned on. For instance, if a user wants to turn on a television that is powered off at the end of a predetermined time period according to a power savings rule, at first, power is applied by the controller, then the television is turned on by means of the signal transmitter on the controller.

Thanks to the advantages brought by the present invention, both the energy is saved that many electronic devices consume during their standby period, and the turning ON and OFF operations of multiple electronic devices by the user is facilitated.

## Claims

1. A method of controlling the ON, STANDBY, or the OFF state of at least one electronic device in a system in which multiple electronic devices are present and at least one of such electronic devices is controlled by means of the remote control signals of at least one of such devices, in which method
• such electronic devices are connected to a controller for controlling the ON, standby, and OFF mode of such devices;
• said controller detects the remote control signals controlling the electronics devices;
• once a signal is transmitted from at least one of the remote controls of such electronic devices for turning ON, turning OFFor switching to the standby mode such an electronic device, said controller controls the switching to the standby mode, turning ON, or turning OFF of at least one electronic device according to the ON, standby, or OFF state of that electronic device as required by at least one predetermined turning ON, switching to the standby mode, or turning OFF rule of said controller;
• once a signal is transmitted from at least one remote control of such electronic devices for switching an electronic device to the standby mode, said controller shuts off the power of at least one electronic device according to the ON, standby, or OFF state of that electronic device as required by a predetermined turning OFF rule of said controller;
• once a signal is transmitted from at least one remote control of such electronic devices for turning ON an electronic device, said controller supplies power to at least one electronic device according to the ON, standby, or OFF state of that electronic device as required by a predetermined turning ON rule of said controller;
• once a signal is transmitted from at least one remote control of such electronic devices for turning ON an electronic device already in the OFF state, said controller provides the turning ON of at least one electronic device according to a predetermined turning ON rule of said controller.

2. A method according to Claim 1, wherein the rules of the controller for turning ON, switching to the standby mode, or turning OFF operations are maintained on a nonvolatile memory of the controller.

3. A method according to Claim 1 or Claim 2, wherein the rules maintained on said memory of said controller for turning ON, switching to the standby mode, or turning OFF operations are previously determined by the manufacturer.

4. A method according to Claim 1 or Claim 2, wherein the rules maintained on said memory of said controller for turning ON, switching to the standby mode, or turning OFF operations can be altered by the user afterwards.

5. A method according to Claim 1 or Claim 2, wherein the rules maintained on said memory of said controller for turning ON, switching to the standby mode, or turning OFF operations can be altered by the manufacturer afterwards.

6. A method according to Claim 1, wherein said controller is provided with plugs, i.e. power sockets on itself which comply with such electronic devices for connecting such electronic devices to said controller.

7. A controller system for controlling the turning ON, switching to the standby mode, or turning OFF state of at least one electronic device in a system in which a plurality of electronic devices are present and at least one of such devices is controllable by means of a remote control, said controller system being **characterized in that**
• a controller is comprised for controlling the ON, standby, and OFF mode of such electronic devices,
• said controller comprises a signal receiver (10) and signal transmitter (11) unit capable of receiving and transmitting the remote control signals controlling said electronic devices,
• once a signal is transmitted from the remote controls of such electronic devices for turning ON or switching to the standby MODE an electronic device, this signal is detected both by the electronic device and the signal receiving unit of the controller (10, 12),
• said controller maintains on its nonvolatile memory (13) predetermined turning ON, switching to the standby mode, or turning OFF rules according to the standby or OFF mode of such controlled electronic device,
• at least one device (12, 15) is comprised for shutting off or supplying the power of at least one electronic device connected to said controller according to said turning ON, switching to the standby mode, or turning OFF rules.

8. A method according to Claim 1 or 7, wherein said remote control signals are infrared signals.

9. A method according to Claim 1 or 7, wherein said remote control signals are radio frequency signals.

## Patentansprüche

1. Verfahren zum Steuern des Einschalt-, Bereitschafts- oder Ausschaltzustands mindestens eines elektronischen Geräts in einem System, in dem mehrere elektronische Geräte vorhanden sind und mindestens eines dieser elektronischen Geräte mittels Fernsteuerungssignalen von mindestens einem dieser Geräte gesteuert wird, wobei in diesem Verfahren:
• diese elektronischen Geräte an ein Steuergerät zum Steuern des Einschalt-, Bereitschafts- und Ausschaltmodus dieser Geräte angeschlossen sind;
• das Steuergerät die Fernsteuerungssignale erfasst, die die elektronischen Geräte steuern;
• sobald ein Signal von mindestens einer Fernsteuerung dieser elektronischen Geräte übertragen wird, um ein solches elektronisches Gerät einzuschalten, auszuschalten oder in den Bereitschaftsmodus zu schalten, das Steuergerät das Schalten in den Bereitschaftsmodus, das Ein- oder Ausschalten mindestens eines elektronischen Geräts je nach dem Einschalt- Bereitschafts- oder Ausschaltzustand dieses elektronischen Geräts steuert, und zwar wie durch mindestens eine vorbestimmte Regel des Steuergeräts zum Einschalten, Schalten in den Bereitschaftszustand oder Ausschalten angeordnet;
• sobald ein Signal von mindestens einer Fernsteuerung dieser elektronischen Geräte übertragen wird, um ein elektronisches Gerät in den Bereitschaftsmodus zu schalten, das Steuergerät den Strom mindestens eines elektronischen Geräts je nach dem Einschalt-, Bereitschafts- oder Ausschaltzustand dieses elektronische Geräts unterbricht, und zwar wie durch eine vorbestimmte Ausschaltregel des Steuergeräts angeordnet;
• sobald ein Signal von mindestens einer Fernsteuerung dieser elektronischen Geräte übertragen wird, um ein elektronisches Gerät einzuschalten, das Steuergerät Strom an mindestens ein elektronisches Gerät je nach dem Einschalt-, Bereitschafts- oder Ausschaltzustand dieses elektronischen Geräts liefert, und zwar wie durch eine vorbestimmte Einschaltregel des Steuergeräts angeordnet;
• sobald ein Signal von mindestens einer Fernsteuerung dieser elektronischen Geräte übertragen wird, um ein bereits im Ausschaltzustand befindliches elektronisches Gerät einzuschalten, das Steuergerät das Einschalten des mindestens einen elektronischen Geräts nach einer vorbestimmten Einschaltregel des Steuergeräts bewerkstelligt.

2. Verfahren nach Anspruch 1, wobei die Regeln des Steuergeräts zum Einschalten, Schalten in den Bereitschaftsmodus oder Ausschaltvorgängen in einem nichtflüchtigen Speicher des Steuergeräts hinterlegt sind.

3. Verfahren nach Anspruch 1 oder Anspruch 2, wobei die im Speicher des Steuergeräts hinterlegten Regeln für Einschalten, Schalten in den Bereitschaftsmodus oder Ausschaltvorgänge vorab vom Hersteller bestimmt werden.

4. Verfahren nach Anspruch 1 oder Anspruch 2, wobei die im Speicher des Steuergeräts hinterlegten Regeln für Einschalten, Schalten in den Bereitschaftsmodus oder Ausschaltvorgänge später vom Benutzer verändert werden können.

5. Verfahren nach Anspruch 1 oder Anspruch 2, wobei die im Speicher des Steuergeräts hinterlegten Regeln für Einschalten, Schalten in den Bereitschaftsmodus oder Ausschaltvorgänge später vom Hersteller verändert werden können.

6. Verfahren nach Anspruch 1, wobei das Steuergerät mit Steckern, d.h. Stromsteckdosen an sich selbst versehen ist, die zu diesen elektronischen Geräten passen, um die elektronischen Geräte an das Steuergerät anzuschließen.

7. Steuergerätesystem zum Steuern des Einschaltzustands, des Schaltens in den Bereitschaftsmodus oder des Ausschaltzustands mindestens eines elektronischen Geräts in einem System, in dem mehrere elektronische Geräte vorhanden sind und mindestens ein solches Gerät mittels einer Fernsteuerung gesteuert werden kann, wobei das Steuergerätesystem **dadurch gekennzeichnet ist, dass**
• ein Steuergerät enthalten ist, um den Einschalt-, Bereitschafts- und Ausschaltmodus dieser elektronischen Geräte zu steuern,
• das Steuergerät eine Einheit aus einem Signalempfänger (10) und einem Signalsender (11) umfasst, die in der Lage ist, die Fernsteuerungssignale zu empfangen und zu übertragen, die die elektronischen Geräte steuern,
• sobald ein Signal von den Fernsteuerungen dieser elektronischen Geräte übertragen wird, um ein elektronisches Gerät einzuschalten oder in den Bereitschaftsmodus zu schalten, dieses Signal sowohl vom elektronischen Gerät als auch von der Signalempfangseinheit (10, 12) des Steuergeräts erfasst wird,
• das Steuergerät in seinem nichtflüchtigen Speicher (13) vorbestimmte Regeln zum Einschalten, Schalten in den Bereitschaftsmodus oder Ausschalten je nach dem Bereitschafts- oder Ausschaltzustand eines solchen gesteuerten elektronischen Geräts hinterlegt hat,
• mindestens eine Vorrichtung (12, 15) enthalten ist, um den Strom mindestens eines elektronischen Geräts, das an das Steuergerät angeschlossenen ist, je nach den Regeln zum Einschalten, Schalten in den Bereitschaftsmodus oder Ausschalten, zu unterbrechen oder es damit zu versorgen.

8. Verfahren nach Anspruch 1 oder 7, wobei es sich bei den Fernsteuerungssignalen um Infrarotsignale handelt.

9. Verfahren nach Anspruch 1 oder 7, wobei es sich bei den Fernsteuerungssignalen um Funkfrequenzsignale handelt.

## Revendications

1. Procédé pour commander l'état de marche, de veille ou d'arrêt d'au moins un dispositif électronique dans un système dans lequel de multiples dispositifs électroniques sont présents et au moins un de ces dispositifs électroniques est commandé au moyen des signaux de commande à distance d'au moins un de ces dispositifs, procédé dans lequel
- ces dispositifs électroniques sont connectés à un dispositif de commande pour commander le mode de marche, de veille ou d'arrêt de ces dispositifs ;
- ledit dispositif de commande détecte les signaux de commande à distance commandant les dispositifs électroniques ;
- une fois qu'un signal a été transmis à partir d'au moins une des commandes à distance de tels dispositifs électroniques pour mettre en marche, mettre à l'arrêt ou commuter dans le mode de veille un tel dispositif électronique, ledit dispositif de commande commande la commutation dans le mode de veille, la mise en marche ou la mise à l'arrêt d'au moins un dispositif électronique en fonction de l'état de marche, de veille ou d'arrêt de ce dispositif électronique comme imposé par au moins une règle prédéterminée de mise en marche, commutation dans le mode de veille ou mise à l'arrêt dudit dispositif de commande ;
- une fois qu'un signal a été transmis à partir d'au moins une des commandes à distance de tels dispositifs électroniques pour commuter un dispositif électronique dans le mode de veille, ledit dispositif de commande coupe l'alimentation électrique d'au moins un dispositif électronique en fonction de l'état de marche, de veille ou d'arrêt de ce dispositif électronique comme imposé par au moins une règle prédéterminée de mise à l'arrêt dudit dispositif de commande ;
- une fois qu'un signal a été transmis à partir d'au moins une des commandes à distance de tels dispositifs électroniques pour mettre en marche un dispositif électronique, ledit dispositif de commande fournit l'alimentation électrique à au moins un dispositif électronique en fonction de l'état de marche, de veille ou d'arrêt de ce dispositif électronique comme imposé par au moins une règle prédéterminée de mise en marche dudit dispositif de commande ;
- une fois qu'un signal a été transmis à partir d'au moins une des commandes à distance de tels dispositifs électroniques pour mettre en marche un dispositif électronique déjà dans l'état d'arrêt, ledit dispositif de commande fournit la mise en marche d'au moins un dispositif électronique en fonction d'une règle prédéterminée de mise en marche dudit dispositif de commande.

2. Procédé selon la revendication 1, dans lequel les règles du dispositif de commande pour des opérations de mise en marche, commutation dans le mode de veille ou mise à l'arrêt sont conservées dans une mémoire non volatile du dispositif de commande.

3. Procédé selon la revendication 1 ou 2, dans lequel les règles conservées dans ladite mémoire dudit dispositif de commande pour des opérations de mise en marche, commutation dans le mode de veille ou mise à l'arrêt sont préalablement déterminées par le fabricant.

4. Procédé selon la revendication 1 ou 2, dans lequel les règles conservées dans ladite mémoire dudit dispositif de commande pour des opérations de mise en marche, commutation dans le mode de veille ou mise à l'arrêt peuvent être modifiées successivement par l'utilisateur.

5. Procédé selon la revendication 1 ou 2, dans lequel les règles conservées dans ladite mémoire dudit dispositif de commande pour des opérations de mise en marche, commutation dans le mode de veille ou mise à l'arrêt peuvent être modifiées successivement par le fabricant.

6. Procédé selon la revendication 1, dans lequel ledit dispositif de commande est muni sur lui-même de prises, c'est-à-dire de prises d'alimentation électrique, qui s'adaptent à de tels dispositifs électroniques pour connecter ces dispositifs électroniques audit dispositif de commande.

7. Système de commande pour commander l'état de marche, de commutation dans le mode de veille ou d'arrêt d'au moins un dispositif électronique dans un système dans lequel une pluralité de dispositifs électroniques sont présents et au moins un de ces dispositifs peut être commandé au moyen d'une commande à distance, ledit système de commande étant **caractérisé en ce que**
- un dispositif de commande est prédisposé pour commander le mode de marche, de veille ou d'arrêt de ces dispositifs électroniques ;
- ledit dispositif de commande comprend une unité de réception de signaux (10) et de transmission de signaux (11) capable de recevoir et transmettre les signaux de commande à distance commandant lesdits dispositifs électroniques ;
- une fois qu'un signal a été transmis à partir des commandes à distance de tels dispositifs électroniques pour mettre en marche ou commuter dans le mode de veille un dispositif électronique, ce signal est détecté à la fois par le dispositif électronique et l'unité de réception de signaux du dispositif de commande (10, 12) ;
- ledit dispositif de commande conserve dans sa mémoire non volatile (13) des règles prédéterminées de mise en marche, commutation dans le mode de veille ou mise à l'arrêt en fonction du mode de veille ou d'arrêt de ce dispositif électronique commandé,
- au moins un dispositif (12, 15) est prédisposé pour couper ou fournir l'alimentation électrique d'au moins un dispositif électronique connecté audit dispositif de commande en fonction desdites règles de mise en marche, commutation dans le mode de veille ou mise à l'arrêt.

8. Procédé selon la revendication 1 ou 7, dans lequel lesdits signaux de commande à distance sont des signaux infrarouges.

9. Procédé selon la revendication 1 ou 7, dans lequel lesdits signaux de commande à distance sont des signaux de radiofréquence.
